# EUROPÄISCHE PATENTSCHRIFT

(11) **EP 1 251 975 B1**
(45) Veröffentlichungstag und Bekanntmachung des Hinweises auf die Patenterteilung: **16.06.2004**
(21) Anmeldenummer: 01901097.4
(22) Anmeldetag: 26.01.2001
(51) Int. Cl.: B05D 7/24, C23C 16/30

(54) **SCHUTZ- UND/ODER DIFFUSIONSSPERRSCHICHT**
PROTECTIVE AND/OR DIFFUSION BARRIER LAYER
COUCHE DE PROTECTION ET/OU COUCHE DE BARRAGE DE DIFFUSION

(30) Priorität: 27.01.2000 CH 1582000
(43) Veröffentlichungstag der Anmeldung: 30.10.2002
(73) Patentinhaber: Incoat GmbH, 8803 Rüschlikon (CH)
(72) Erfinder: MOSER, Eva, Maria, CH-8224 Löhningen (CH)
(74) Vertreter: patentanwälte breiter + wiedmer ag
(86) Internationale Anmeldenummer: PCT/CH2001/000059
(87) Internationale Veröffentlichungsnummer: WO 2001/055489

(56) Entgegenhaltungen:
- EP-A- 0 423 996
- WO-A-99/63129
- YOSHIHIRO ASANO: "METAL-CONTAINING PLASMA-POLYMERIZED FILMS" THIN SOLID FILMS., Bd. 105, Nr. 1, Juli 1983 (1983-07), Seiten 1-8, XP002139236 ELSEVIER-SEQUOIA S.A. LAUSANNE., CH ISSN: 0040-6090
- BIEDERMAN H ET AL: "METAL DOPED FLUOROCARBON POLYMER FILMS PREPARED BY PLASMA POLYMERIZATION USING AN RF PLANAR MAGNETRON TARGET" NUCLEAR INSTRUMENTS & METHODS IN PHYSICS RESEARCH,NL,NORTH-HOLLAND PUBLISHING COMPANY. AMSTERDAM, Bd. 212, Nr. 1/03, 1. Juli 1983 (1983-07-01), Seiten 497-503, XP002032591
- A.M. WROBEL ET AL.: "Plasma Chemical Vapor deposition of Iron- COntaining Hydrogennated Carbon Films Using a Single-Source Precursor" JOURNAL OF CHEMICAL VAPOR DEPOSITION., Bd. 1, Juli 1992 (1992-07), Seiten 42-58, XP000901787 TECHNOMIC PUBLISHING, LANCASTER, PA., US ISSN: 1056-7860 in der Anmeldung erwähnt
- PATENT ABSTRACTS OF JAPAN vol. 017, no. 146 (C-1039), 24. März 1993 (1993-03-24) & JP 04 316677 A (KURARAY CO LTD), 9. November 1992 (1992-11-09)

## Beschreibung

Die Erfindung bezieht sich auf eine chemische, mechanische und/oder optische Schutz- und/oder Diffusionssperrschicht auf einem Metall- oder Kunststoffsubstrat, welche Schicht aus einer organischen Schichtmatrix mit dispergierten metallhaltigen Partikeln besteht, wobei diese Schicht ausgehend von wenigstens einem, auch substituierten Kohlenwasserstoff und einer metallhaltigen Komponente plasmapolymerisiert ist. Weiter betrifft die Erfindung ein Verfahren zum Auftragen der Schutz- und/oder Diffusionssperrschicht, wobei die organische Schichtmatrix durch Plasmapolymerisation aus einem Prozessgas mit wenigstens einem, auch substituierten Kohlenwasserstoff, einer metallhaltigen Komponente und/oder einem anorganischen Gas abgeschieden wird. Schliesslich zeigt die Erfindung Verwendungen der Schutz- und/oder Diffusionssperrschicht und Anwendungen des Verfahrens auf.

Plasmapolymerisationsschichten, wie sie für die organische Schichtmatrix der vorliegenden Erfindung eingesetzt werden, haben den Vorteil, dass sie sich durch eine gezielte Prozessführung in ihren Eigenschaften verändern und auf zahlreiche Anforderungen einstellen lassen. Plasmapolymerisationsschichten können weiter einen hohen Vemetzungsgrad, eine grosse Dichte und eine hinreichende Härte haben. Dank der in der Regel amorphen Schichtstruktur sind sie chemisch und mechanisch stark belastbar, weitgehend mikroporenfrei und haben eine glatte Schichtoberfläche. Dennoch zeichnen sich Plasmapolymerisationsschichten bei entsprechender Prozessführung selbst auf reaktionsträgen Oberflächen durch eine gute Haftfestigkeit aus.

Eine gezielte Prozessführung lässt sich bei Verwendung von Niederdruckplasmen im wesentlichen durch die folgenden Prozessparameter erreichen: Entladungsart, Monomerauswahl, Monomerflussrate, Beschichtungsdauer, Anregungsleistung des Plasmas, Prozessdruck, Substratabstand und angelegtes Bias-Potential.

Ein Plasma, im vorliegenden Fall wie erwähnt ein Niederdruckplasma, wird beispielsweise durch Magnetron-Sputter-, Hochfrequenz- oder Mikrowellen-Entladungsprozesse erzeugt. Die auch substituierten Kohtenwasserstoffmonomere treten durch eine Einlassdüse in einen evakuierbaren Plasmareaktor ein. Dort werden durch energiereiche Elektronen komplexe Reaktionen eingeleitet, welche je nach Prozessführung zu homogenen amorphen oder kristallinen, sowie elastischen oder starren Schichten führen können.

Aus der WO 96/28587 ist eine Plasmakammer zur Polymerisation, aus der WO 99/39842 ein Verfahren zum Beschichten von Substraten mit einer polaren Beschichtung mittels Plasmapolymerisation und aus der WO 99/50472 eine auf einem Substrat abgeschiedene organische Diffusionssperrschicht mit einem apolaren Grundgerüst und hoher Sperrwirkung gegenüber leichtflüchtigen Gasen, Dämpfen und Flüssigkeiten bekannt. Für alle an sich bekannte Details wird ausdrücklich auf diese Publikationen verwiesen. Je nach den im Prozessgas zugeführten Monomeren können hydrophobe apolare Schichten oder hydrophile polare Schichten abgeschieden werden.

Es sind zahlreiche Publikationen bekannt, welche Schutz- und/oder Diffusionssperrschichten aus einer amorphen Kunststoffmatrix, in der Regel eine Kohlenwasserstoffschicht, mit dispergierten Metallpartikeln beschreiben. So wird beispielsweise von A.M. Wróbel, G. Czeremuszkin, H. Szymanowski, H. Shur, J.E. Klemberg-Sapieha, M.R. Wertheimer im Journal of Chemical Vapor Deposition, 1,1992,42, die chemische Abscheidung aus der Gasphase von Eisenpartikeln enthaltenden Kohlenwasserstoffschichten mittels eines Plasmas beschrieben. Weiter ist von E. Feurer und H. Suhr aus Appl. Phys. A 44, 171- 175 (1987), eine entsprechende Abscheidung von Gold enthaltenden Schichten bekannt.

Die metallhaltigen amorphen Kohlenwasserstoffschichten, welche zweckmässig 1 bis 3,5 µm dick sind, zeigen im Vergleich zu metallfreien amorphen Kohlenwasserstoffschichten eine bessere Adhäsion, einen besseren Verschleissschutz, eine gute optische Durchlässigkeit und ausgezeichnete tribologische Eigenschaften. Durch die Inkorporation von elektroaktiven Zentren sind die Schichten insgesamt elektrisch leitfähig, wobei die elektrische Leitfähigkeit mit dem Metallgehalt, der Metallpartikelgrösse und deren Verteilung korreliert.

Yoshihiro Asano beschreibt in der Zeitschrift THIN SOLID FILMS, Vol. 105, Nr. 1, Juli 1983 (1983-07), Seiten 1 bis 8, XP 002139236 ELSEVIER-SEQUDIA S.A. LAUSANNE., CH ISSN: 0040-6090, den Übergang von der amorphen zur kristallinen Phase von Tellur und Bismuth in einer plasmapolymerisierten organischen Schicht. In dieser wissenschaftlichen Untersuchung interessieren insbesondere strukturelle Aspekte. Die optische Dichte des abgeschiedenen Films wird durch Erhitzen erhöht, was zum Übergang vom amorphen in den kristallinen Zustand führt. Die plasmapolymerisierte Schicht aus CS₂ und Styrol, die Halbmetalle Tellur und Bismuth und das Erhitzen lassen nur sehr spezifische Rückschlüsse zu, die nicht auf allgemeine chemische, mechanische und/oder optische Schutz- und/oder Diffusionssperrschichten mit dispergierten metallhaltigen Partikeln ausgedehnt werden können.

Der vorliegenden Erfindung liegt die Aufgabe zugrunde, eine Schutz- und/oder Diffusionssperrschicht und ein Verfahren der eingangs genannten Art zu schaffen, welche hinsichtlich der Sperrwirkung, der elektrochemischen Aktivität und der Elastizität der Schutz- und/oder Diffusionssperrschicht optimiert sind. Weiter sollen die Vorteile der Schutz- und/oder Diffusionssperrschicht in optimalen Verwendungen genutzt werden.

In bezug auf die Schutz- und/oder Diffusionssperrschicht wird die Aufgabe erfindungsgemäss nach dem Kennzeichen gemäss Patentanspruch 1 gelöst.

Spezielle und weiterführende Ausführungsformen sind Gegenstand von abhängigen Patentansprüchen.

Die Schichtdicke d der in der Regel amorphen Schutz- und/oder Diffusionssperrschicht liegt bevorzugt im Bereich von 10 bis 500 nm, insbesondere 20 bis 300 nm.

Die metallhaltigen Partikel haben vorzugsweise eine Grösse von 1 bis 250 nm, insbesondere 10 bis 150 nm, deren Korngrösse liegt zweckmässig unterhalb 20%, insbesondere unterhalb 10% der Schichtdicke d der Schutz- und/oder Diffusionssperrschicht. Die metallhaltigen Partikel sind als einzelne Körner oder als ein Konglomerat von mehreren Körnern - sogenannte Clusters - ausgebildet, welche jedoch in ihrer gesamten Korngrösse stets im Nanometerbereich, d.h. deutlich unterhalb 1 µm, bleiben. Bei den Metallen handelt es sich beispielsweise um Ti, Ta, W, Fe, Zn, Sn, Nb, Au, Pd, Ag, Al und/oder Cu. Die metallhaltigen Partikel können als reine Metalle, Legierungen, aber auch als Metallkarbide oder -oxide vorliegen. Als Beispiele von karbidbildenden Metallen seien Ta, W, Ti und Nb, von oxidbildenden Metallen Fe, Zn und Ag genannt. Eingebracht werden ausschliesslich Metallpartikel, die Karbid- und/oder Oxidpartikel werden an Ort und Stelle gebildet.

Die Schutz- und/oder Diffusionssperrschicht hat insgesamt einen Metallgehalt von vorzugsweise 0,1 bis 65 at%, insbesondere von 1 bis 40 at%, entsprechend der zu erreichenden optimalen elektrischen Leitfähigkeit. Diese ist jedoch nicht das einzige Beurteilungskriterium, beispielsweise ist die beste Kombination eines tiefen Reibungskoeffizienten mit den optimalen mechanischen Eigenschaften mit zu berücksichtigen. Diese können bei einem einstellbaren Metallanteil in der Schutz- und/oder Diffusionssperrschicht erreicht werden, wobei zu beachten ist, dass diese Werte auch von den Parametern Material, Partikelgrösse und deren Verteilung abhängig sind. So bewirkt beispielsweise die Inkorporation von Ti-Partikeln in die Kunststoffmatrix eine bessere Adhäsion auf Stahl als die inkorporation von W-Partikeln.

Bei nichtkarbidbildenden Metallen, wie z.B. Au, Ag, Cu, Pd und Pt, wird reines Metall, allenfalls unter Oxidbildung, in die organische Schichtmatrix eingebaut, in der Regel in eine Kohlenwasserstoffmatrix. Im Falle von Nb wird bis zu einem Metallgehalt von 50 at% ein Gemisch aus karbidisch und polymerartig gebundenem Kohlenstoff beobachtet, oberhalb 50 at% Nb ist nur noch karbidisch gebundener Kohlenstoff vorhanden.

Die feindispers in der isolierenden. organischen Schichtmatrix verteilten submikronen Metallpartikel bzw. Metall-, Metallcarbid- oder Metalloxidcluster bilden oberhalb eines bestimmten Schwellenwertes ein die Matrix durchsetzendes Netzwerk (percolative network), was die elektrische Leitfähigkeit sprunghaft erhöhen kann. Für Gold liegt dieser Schwellenwert z.B. oberhalb 25,4 at%.

Für einen kathodischen Korrosionsschutz sind Metallpartikel, welche unedler sind als das im Substrat vorliegende Metall, in die Schutz- und/oder Diffusionssperrschicht integriert. Desgleichen sind für einen anodischen Korrosionsschutz edlere Metallpartikel als das Metall des Substrats in die Schutz- und/oder Diffusionssperrschicht integriert.

Nach einer besonderen Ausführungsform der Erfindung ist die Konzentration der metallhaltigen Komponenten mit zunehmender Dicke der Schutz- und/oder Diffusionssperrschicht niedriger, insbesondere mit kontinuierlicher Abnahme der Metallpartikel in Richtung der Oberfläche. Nach einer weiteren Ausführungsform kann die Konzentration der Metallpartikel jedoch in der gleichen Richtung auch mit einem entsprechenden Konzentrationsgradienten zunehmen.

Nach einer weiteren Ausführungsform der Erfindung besteht über die Dicke der Schutz- und Diffusionssperrschicht ein Polaritätsgradient, vorzugsweise ein kontinuierlicher.

Die Schutz- und/oder Diffusionssperrschicht kann Partikel aus zwei oder mehr verschiedenen Metallen enthalten, welche als reine Metall-, Legierungs-, Metallkarbid- oder Metalloxidpartikel ausgebildet sind.

In bezug auf das Verfahren zum Auftragen einer erfindungsgemässen Schutz- und Diffusionssperrschicht wird die Aufgabe erfindungsgemäss nach dem Kennzeichen von Patentanspruch 9 gelöst. Spezielle und weiterführende Ausführungsformen des Verfahrens sind Gegenstand von abhängigen Patentansprüchen.

Die Reaktionsgase werden zweckmässig mit einem Trägergas, in aller Regel ein Edelgas und/oder Wasserstoff, eingeleitet, insbesondere mit Helium, Neon und/oder Argon als Edelgas.

Im einfachsten Fall sind die metallhaltigen bzw. metallischen Partikel gleichmässig über die ganze Dicke der erfindungsgemässen Schutz- und/oder Diffusionssperrschicht dispergiert. Dies wird durch gleichmässige Zudosierung der metallischen Komponente während des ganzen Verfahrens erreicht. Nach dem erfindungsgemässen Verfahren kann diese Dosierung nach Bedarf unterschiedlich vorgegeben werden, beispielsweise kontinuierlich zunehmend oder abnehmend. Bei zunehmender Erhöhung oder Erniedrigung der Zudosierung der metallhaltigen Komponente im Reaktionsgas steigt oder sinkt der Metallanteil in der organischen Schichtmatrix entsprechend. Dadurch können die Eigenschaften, insbesondere der elektrischen Leitfähigkeit, gezielt beeinflusst werden. In allen Fällen kann am Schluss noch wenigstens eine Diffusionssperrschicht ohne metallhaltige Partikel aufgetragen werden, also als doppelter Schutz. Die erfindungsgemäss metallhaltige Partikel aufweisende Schutzschicht wird erst aktiv, wenn die äusserste Schicht beschädigt werden sollte, z.B. durch Kratzer, Pinholes oder andere Defekte. Die metalifreie/n Diffusionssperrschicht/en gewährleistet/gewährleisten im Zusammenwirken mit der darunterliegenden Schicht mit metallhaltigen Partikeln eine ausgezeichnete langfristige Schutzwirkung.

Nach einem weiteren erfindungsgemässen Verfahrensmerkmal wird in der organischen Schichtmatrix der Schutz- und/oder Diffusionssperrschicht ein Polaritätsgradient erzeugt, indem im zeitlichen Ablauf des Verfahrens Monomere mit unterschiedlicher Polarität eingeleitet und plasmapolymerisiert werden. Insbesondere können bei einem polaren Substrat vorerst polare, dann zunehmend und gegen das Reaktionsende ausschliesslich apolare Monomere eingeleitet werden, auch ohne metallische Komponenten. Bei einem apolaren Substrat können dagegen vorerst apolare, dann zunehmend und gegen das Reaktionsende ausschliesslich polare Monomere eingeleitet werden, wiederum auch ohne metallische Komponenten. Die äussere Oberfläche der Schutz- und/oder Diffusionssperrschicht ist im ersten Fall hydrophob, im zweiten hydrophil.

Im Folgenden nicht speziell erwähnte Verfahrensparameter ergeben sich aus dem Stand der Technik, es wird dabei insbesondere auf die vorerwähnten WO-Publikationen 96/28587, 99/39842 und 99/50472 verwiesen.

Die Herstellung von metallpartikelhaltigen Kunststoffschichten, in der Regel amorphen Kohlenwasserstoffschichten, erfolgt für den kathodischen und anodischen Schutz bevorzugt nach einer der folgenden Varianten.
- Die Metallpartikel werden durch Kathodenzerstäubung eines entsprechenden Targets bei gezündetem Plasma erzeugt und in die Kunststoffmatrix inkorporiert. Wie bereits erwähnt, kann dies durch reaktives RF- oder DC-Sputtern sowie durch reaktives Magnetronsputtering (RF, DC, Tieffrequenz, mittlere Frequenz, gepulster DC) erfolgen, wobei RF Radiofrequenz und DC Gleichstrom bedeutet.
- Weiter können die Metallpartikel durch Verdampfen von entsprechenden Metallstücken, insbesondere mittels Bogenentladung sowie resistiver oder RF(Hochfrequenz)-Erwärmung erzeugt, vom Prozessgasstrom mitgerissen und feinverteilt in die Kunststoffmatrix inkorporiert werden.
- Schliesslich kann eine metallorganische Verbindung zersetzt und unter Bildung der Kunststoffmatrix mit den feindispersen Metallpartikeln niedergeschlagen werden. Dieses Verfahren wird Plasma-MOCVD (Plasma-Metal Organic Chemical Vapour Deposition) genannt. Beispielsweise kann Eisen (III) -Acetylacetonat als einziges Edukt für die Metallpartikel und die amorphe organische Schichtmatrix verwendet werden. Ein weiteres Beispiel für eine einsetzbare metallorganische Verbindung ist Al (CₓH_{y})₄, wobei x,y = 1,2...n. Weitere Beispiele für gut geeignete metallische Komponenten von metallorganischen Verbindungen sind Cu, Ti, Ag, Au, W, Pt, Zn und Pd.

Ein wesentlicher Vorteil der Erfindung besteht darin, die bezüglich der Sperrwirkung und Elastizität optimierten Schutz- und Diffusionssperrschichten von submikroner Dicke d auch bezüglich der elektrischen Leitfähigkeit so zu optimieren, dass ein metallisches Substrat automatisch vor Korrosion geschützt ist. Das elektrochemische Potential der Schutz- und Diffusionssperrschicht wird so eingestellt, dass sich der Korrosionsschutz bei Defektstellen selbstheilend ergibt. Es gibt wie bereits kurz angedeutet zwei Typen-von Korrosionsschutz.
- Kathodischer Schutz. Wird das elektrochemische Potential durch entsprechende Metallpartikel in die negative Richtung verschoben, liegt das Ruhepotential tiefer als das Gleichgewichtspotential für die Metallauflösung. Eine Korrosion kann nicht stattfinden, weil sich das Potential im Stabilitätsgebiet des Metalls befindet. Die unedlen Metallpartikel werden selbst oxidiert, an der Schnittstelle der defekten Schutzschicht auf dem kathodisch geschützten Substrat findet eine Reduktionsreaktion statt. Die Metallpartikel werden zu entsprechenden Metallionen oxidiert, wobei Elektronen frei werden. An der Substratoberfläche verbinden sich zwei Protonen unter Bildung von H₂ mit zwei Elektronen. Bei einer feuchten Substratfläche unter Sauerstoffzutritt können auch Hydroxylionen gebildet werden.
   Die Wasserstoffbildung könnte während der Blasenbildung problematisch werden, weil dies zu Eigenspannungen führt. Es wird jedoch nur Wasserstoff freigesetzt, wenn das Potential zu sehr tiefen Werten verschoben wird. Die Wahl der Metallpartikel ist deshalb von grösster Bedeutung, das erforderliche Potential kann an die richtige Stelle gebracht und die Eigenauflösung des unedlen Metalles kann langsam ablaufen. So rostet beispielsweise das Eisen beim Kontaktieren mit Zink nicht mehr, weil sich Zink langsam auflöst. In einem Schutzlack werden deshalb Zinkstaubpigmente verwendet.
- Anodischer Schutz. Passivierbare Metalle wie Aluminium bilden bei höheren Potentialen stabile und gut schützende Oxidfilme. Der Kontakt mit einem edleren Metall, beispielsweise Platin, führt das Potential in den Bereich der stabilen Passivität. Der Passivfilm könnte sich sonst unter diesen Bedingungen gar nicht spontan bilden.

Die edleren Metallpartikel wirken als Kathode und die Reduktionsreaktion läuft auf der Oberfläche der Metallpartikel ab, wobei sich diese selbst nicht ändern.

Das Verfahren ist nicht auf die inkorporierung eines einzigen speziellen Metalls, einer Legierung, eines Metallkarbids oder Metalloxids in die Kunststoffmatrix zur Bildung einer Schutz- und/oder Diffusionssperrschicht beschränkt, es können auch gleichzeitig Partikel aus mehreren reinen Metallen und/oder anderen metallhaltigen Komponenten in die Schutz- und/oder Diffusionssperrschicht inkorporiert werden. Dies erfolgt vorteilhaft durch den Einsatz eines Targets mit verschiedenen Metallsegmenten, wobei auch mehrere Kathodenzerstäuber eingesetzt werden können. Der Sputterprozess kann durch Anordnung eines Magnetfeldes in balancierter oder nicht balancierter Ausführungsform betrieben werden.

Schliesslich kann das Substrat mit einem eingeschalteten Bias (DC, 10 kHz bis 100 MHz) arbeiten sowie erwärmt oder gekühlt werden.

Nach allen Varianten und weiterbildenden Ausführungsformen des erfindungsgemässen Verfahrens ist das Abscheiden von Metallpartikeln mit einer Plasmapolymerisation von Monomeren überlagert.

Je nach Substrat bietet die vorliegende Erfindung wenigstens einen der nachfolgenden Vorteile:
- Korrosionsschutz
- Mechanische Eigenschaften: Gute Haftung, Kratzschutz
- Chemische Eigenschaften: Inert, hydrophob oder hydrophil
- Optische Eigenschaften: UV-Absorption, Farbe, Brechungsindex
- Tribologische Eigenschaften: Verschleissschutz, niedriger Reibungskoeffizient
- Über weiten Bereich variierbare elektrische Eigenschaften: 10⁻⁴ bis 10¹⁶ Ohm/cm, Antistatic- und Antismog-Effekt
- Gute Wärmeleitfähigkeit

Dank der durch gezielte Prozessführung in ihren Eigenschaften über einen weiten Bereich veränderbaren Schutz- und Diffusionssperrschichten haben diese ein weites Anwendungsfeld. Von wesentlicher Bedeutung ist der Korrosionsschutz für Metalle, wie Silber, Aluminium, Stahl, Kupfer usw., durch kathödischen oder anodischen Schutz mit dem Metallpartikel entsprechenden elektrochemischen Potential. Konkret sind dies beispielsweise Ag-Leiterbahnen, Al-Reflektoren, Al- oder Messingbänder. Eine weitere wesentliche Verwendung sind elektrisch leitende und optisch attraktive flexible Diffusionsbarrieren für Kunststoffsubstrate, insbesondere für Verpackungen aus Kunststoffen, wobei dank der einstellbaren elektrischen Leitfähigkeit der Schutz- und/oder Diffusionssperrschichten auch ein Antistatikeffekt erzielt, d.h. eine elektrostatische Aufladung des Kunststoffs verhindert, weiter gegen UV-Strahlen Schutz verliehen und eine attraktive Farbgebung erreicht werden kann.

Neben allen üblichen und naheliegenden Anwendungen des erfindungsgemässen Verfahrens können auch Fasern, insbesondere Textil-, Glas-, Keramik- und Metallfasern, Whiskers und Drähte elektrisch leitend beschichtet werden.

In Tabelle 1 sind die Eigenschaften von metalldvtierten, plasmapolymerisierten Schutz- und Diffusionssperrschichten auf einer 12 µm dicken transparenten PET-Folie als Proben 1 bis 10 aufgelistet. Die Schichten sind hinsichtlich Ihrer Eigenschaften als Diffusionssperre geprüft, insbesondere bezüglich der Sauerstoff- und Wasserdampfdurchlässigkeit (OXTR bzw. WVTR). Alle notwendigen Aufgaben ergeben sich aus der nachfolgenden Tabelle 1 (Seite 17) selbst oder aus ihrer Legende.

### Ausführungsbeispiele

Durch reaktives, gepulstes DC-Magnetron-Sputtem, überlagert mit einer gasphaseninduzierten Plasmapolymerisation in einer Hochvakuumkammer, werden amorphe Kohlenwasserstoffschichten mit feindispers eingelagerten Silberpartikeln, welche die Schutz- und/oder Diffusionssperrschicht bilden, abgeschieden. Dabei werden folgende Parameter eingesetzt:
- Target: Silber (Durchmesser 200 mm)
- Target Leistung: 100 bis 600 W
- Distanz Target- Substrat: variierbar, meistens 100 mm
- Reaktive Gase: Acethylen, Methan oder Gemische davon
- Gasflüsse: Argon: 20 cm³ /min, Acethylen (CₓH_{y}): 1 bis 50 cm³/min
- Prozessdruck: 10⁻³ bis 10⁻¹ mbar
- Substrat Material: Folien aus Al, Ag, Cu oder Stahl
- Substrat Potential (Bias): 0 bis -600V
- Substrat Temperatur: 20°C bis 300°C

Weitere Ausführungsbeispiele, welche auch Gegenstand von abhängigen Patentansprüchen sind, werden in der Zeichnung dargestellt. Es zeigen schematisch:
- Fig. 1 einen Schnitt durch eine Schutz- und Diffusionssperrschicht,
- Fig. 2 eine Variante von Fig. 1,
- Fig. 3 eine Draufsicht auf blanke und beschichtete Al-Folien,
- Fig. 4 einen Schnitt gemäss Fig. 1 mit zwei zusätzlichen Oberflächenschichten,
- Fig. 5 eine Variante gemäss Fig. 1 mit einem Gradienten der metallhaltigen Partikel,
- Fig. 6 eine Variante gemäss Fig. 1 mit einer elektrisch leitenden Schutz- und Diffusionssperrschicht,
- Fig. 7 ein Tiefenprofil einer Schutz- und Diffusionssperrschicht, und
- Fig. 8 eine Variante gemäss Fig. 7.

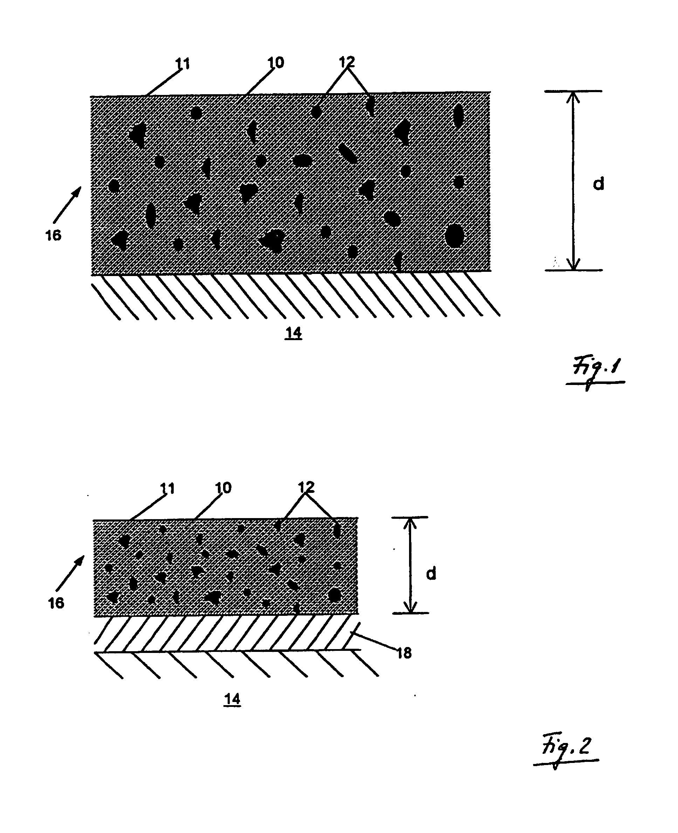

Eine gemäss vorliegendem Ausführungsbeispiel hergestellte Schutz- und/oder Diffusionssperrschicht 16 ist in Fig. 1 schematisch dargestellt. Eine amorphe, dreidimensional vemetzte Kohlenwasserstoffmatrix 10 mit der Oberfläche 11 enthält metallhaltige Partikel 12, die Matrix wird auf ein Substrat 14 aufgetragen. Die Kohlenwasserstoffmatrix 10 mit den metallhaltigen Partikeln 12 bildet die Schutz- und/oder Diffusionssperrschicht 16, welche fest auf dem Substrat 14 haftet und dieses chemisch, mechanisch und/oder optisch schützt. Im vorliegenden Fall hat die Schutz- und/oder Diffusionssperrschicht eine Dicke d von 20 nm und ist auf eine Substratfolie 14 von 12 µm aufgetragen. Je nach Metall bestehen die wenige Nanometer grossen Partikel 12 aus polymer- oder diamantartig an die Kohlenwasserstoffmatrix gebundenem Metall, einem Interface aus Metallkarbid, Metalloxid, Metallkarbid-, Metalloxidkristalliten oder Kombinationen daraus. Die metallhaltigen Partikel 12 können auch als entsprechende Clusters ausgebildet sein.

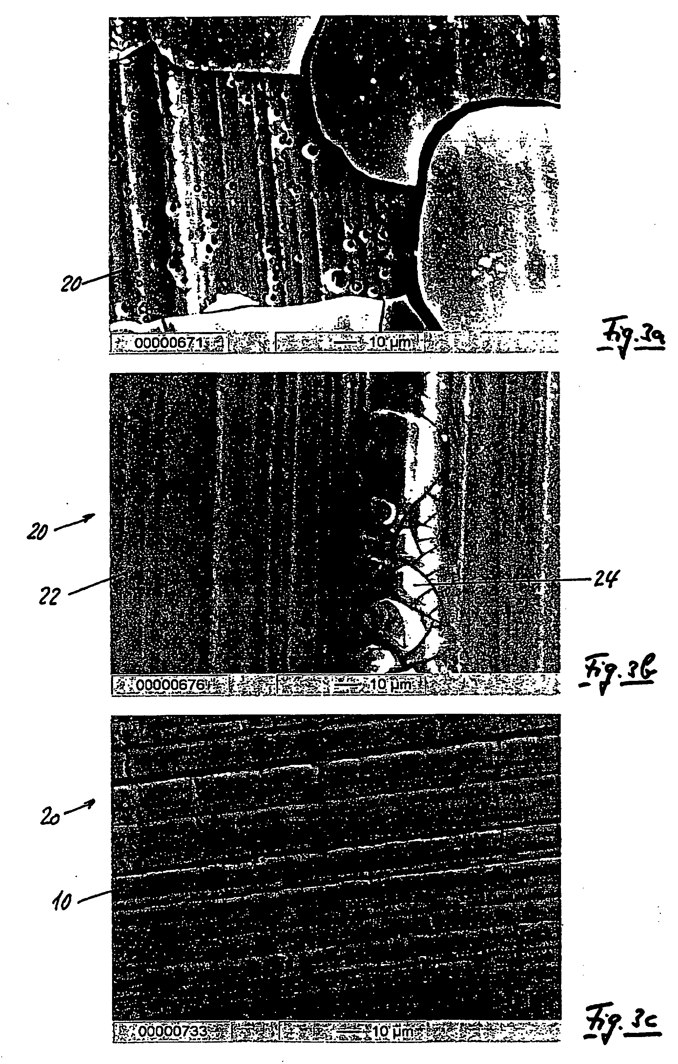

In Fig. 2 ist zwischen der Schutz- und/oder Diffusionssperrschicht 12 und dem Substrat 14 eine metallische Zwischenschicht 18 aufgetragen.

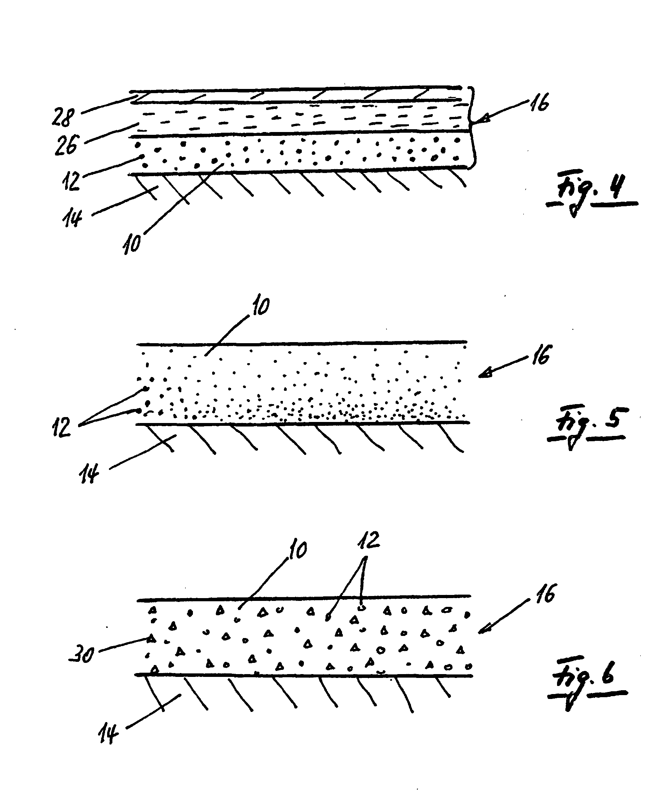

Fig. 3a zeigt eine blanke Aluminiumfolie 20, welche während einem 10 Tage dauernden Korrosionstest mit einer NaCl-Lösung besprüht worden ist. Die Al₂O₃-Schicht ist durchfurcht, durchlöchert und blättert teilweise ab.

Die in Fig. 3b dargestellte, mit einer plasmapolymerisierten, 80 nm dicken reinen Kohlenwasserstoffschicht 22 geschützte Aluminiumfolie 20 übersteht die zehntägige Salzlösungsbesprühung wesentlich besser. An mehreren Stellen werden jedoch "Pinholes" auf, als defekte Korrosionsherde 24 gut erkennbar.

Die gemäss Fig. 3c mit einer erfindungsgemässen organischen Schichtmatrix 10 mit nicht sichtbaren Metallpartikeln aus Silber auf einer Aluminiumfolie übersteht die zehntägige Salzlösungsbesprühung makellos, es sind keine Korrosionsherde erkennbar.

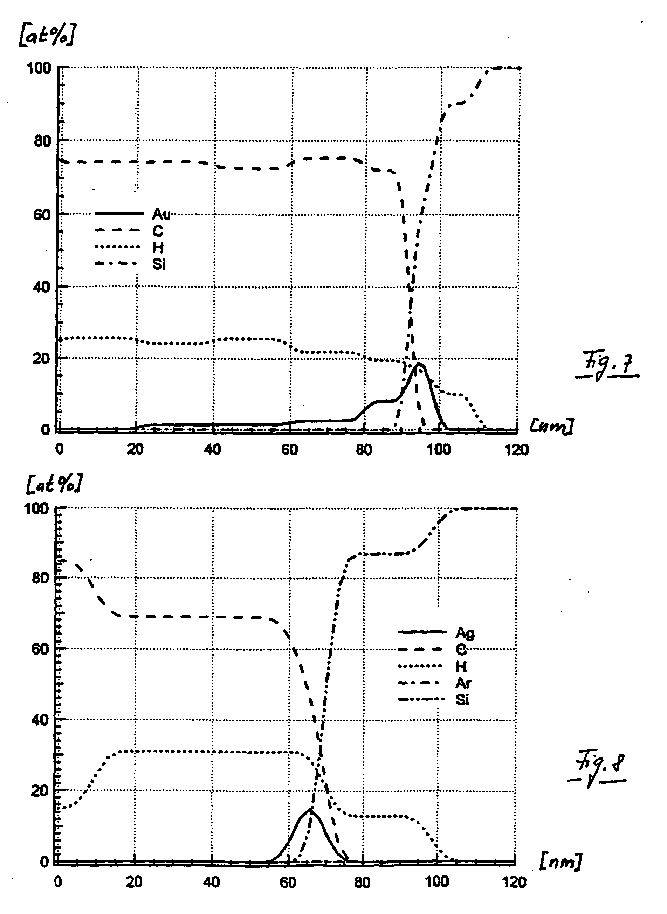

Fig. 4 entspricht in verkleinertem Massstab im wesentlichen Fig. 1 und hat zwei auf die organische Schichtmatrix 10 mit den regelmässig eingebrachten metallhaltigen Partikeln 12 aufgebrachte Schichten 26,28 ohne Metallanteil. Eine erste Diffusionssperrschicht 26 ist elektrisch nicht leitend und apolar ausgebildet, eine zweite Diffusionssperrschicht 28, welche die Oberfläche bildet, ist polar ausgebildet.

Nach weiteren, nicht dargestellten Varianten kann
- die erste Diffusionssperrschicht 26 polar, die zweite Schicht 28 apolar ausgebildet, oder
- nur die erste oder zweite Schicht 26,28 aufgebracht sein.

Die Diffusionssperrschichten 26,28 schützen einzeln oder gemeinsam die organische Schichtmatrix 10 mit den metallhaltigen Partikeln 12 vor mechanischen und/oder chemischen Einwirkungen. Falls eine oder beide der Schichten 26,28 verletzt werden, tritt die volle Wirkung der organischen Schichtmatrix 10 mit den metallhaltigen Partikeln 12 ein.

Die Schutz- und/oder Diffusionssperrschicht 16 umfasst also immer eine organische Schichtmatrix 10 mit metallhaltigen Partikeln 12 und wahlweise eine oder zwei weitere Diffusionssperrschichten 26,28 ohne Metallanteil, welche letztere die Oberfläche bilden.

Fig. 5 zeigt eine auf einem Substrat 14 abgeschiedene organische Schichtmatrix 10, in welcher die metallhaltigen Partikel 12 nicht wie in Fig. 4 homogen, sondern mit einem Gradienten abgeschiedenen Partikeln. In Richtung der Oberfläche nimmt der Anteil von metallhaltigen Partikeln rasch ab und kann zu Null werden.

Es können auch gleichzeitig mit zwei verschiedenen Verfahren metallhaltige Partikel 12 in die organische Schichtmatrix abgeschieden werden. Homogen feinverteilte Metallpartikel 12 werden mit Plasma-MOCVD, der chemischen Abscheidung aus der Gasphase mit Verwendung von metallorganischen Komponenten hergestellt, beispielsweise Ag, Au, Zn, Pt, Al, Pd und/oder Fe. Die so hergestellten feinkörnigen Partikel 12 können identisch oder verschieden sein. Wesentlich ist, dass die Partikeigrösse im Nanometerbereich liegt. Selbstverständlich können auch nach der Ausführungsform von Fig. 5 weitere elektrisch nicht leitende Schichten gemäss Fig. 3 oder 4 zusätzlich aufgebracht werden.

Eine weitere Variante gemäss Fig. 6 umfasst eine auf ein Substrat 14 aufgebrachte organische Schichtmatrix 10 mit regelmässig verteilten metallhaltigen Partikeln 12. Die hier wie in den übrigen Ausführungsbeispielen zweckmässig amorph ausgebildete Kohlenwasserstoffmatrix besteht beispielsweise aus Polypyrol, Polyanilin, Polythiophen oder Polyacethylen, jeweils mit lod 30 dotiert ist sie elektrisch leitfähig, weil sich organische Plasmapolymere als Matrix pseudo-metallisch verhalten.

Als speziell interessant hat sich die Abscheidung von Metallpartikeln aus me-tallorganischen Verbindungen mittels eines Plasmas erwiesen. Besonderes Augenmerk wird auf die nicht toxischen Metalle Au, Ag, Pd und W gerichtet. Pt weist ein beträchtliches ökotoxisches Potenzial auf, dies insbesondere mit Blick auf Aluminiumoxidkatalysatoren.

Für die Abscheidung von Metallen aus metallorganischen Verbindungen mittels eines Plasmas bestehen noch mehrere weitere Verfahren, die hier jedoch lediglich stichwortartig aufgeführt werden können:
- Thermische Evaporation
- Ionenbeschichtung
- ARE, aktivierte reaktive Verdampfung
- Kathodischer Vakuumbogen
- Laser CVD
- Laserphotolyse

In Fig. 7 ist das Tiefenprofil für Probe 6 in Tabelle 1 aufgezeichnet, wobei auf der Abszisse die Schichttiefe in Nanometern, auf der Ordinate die chemische Zusammensetzung in Atomprozent aufgetragen ist. Die gemäss Tabelle 1 94 nm dicke Schutz- und/oder Diffusionssperrschicht 16 enthält insgesamt 4,4 at% Gold in der Kohlenwasserstoffmatrix 10. Im Tiefenprofil ist zu sehen, dass die auf einen Si-Wafer abgeschiedene Schicht an der Oberfläche weniger Gold enthält als an der Grenzfläche zum Substrat 14. In etwa 60 nm Schichttiefe steigt der Konzentrationsgradient von Gold zur Grenzfläche hin kontinuierlich und deutlich sichtbar an. Gleichzeitig sinkt der Wasserstoffgehalt und bei etwa 90 nm Schichttiefe auch der Kohlenstoffgehalt. Der Konzentrationsanstieg von Silizium korreliert mit der Abnahme von Kohlenstoff und ist, im Unterschied zum Gold nicht "ausgeschmiert". Der Wasserstoff ist einige Nanometer in das Silizium hineinmigriert, was ebenfalls deutlich erkennbar ist.

Das Tiefenprofil von Probe 6 zeigt, dass das Schichtmetall in der ganzen Schicht verteilt sein kann und mit Konzentrationsgradienten zur Grenzphase hin deutlich ansteigen kann. Die Abscheidung erfolgte durch DC-Sputtern mit dem Substrat auf Erde.

Fig. 8 zeigt ein äquivalentes Tiefenprofil für Probe 8 gemäss Tabelle 1. Bei dieser Probe wird in der 51nm dicken Schicht eine Silberkonzentration von insgesamt 0,02 at% nachgewiesen. In den obersten 10 nm ändert das Verhältnis von Kohlenstoff zu Wasserstoff, was auf eine nachträgliche Oberflächenreaktion schliessen lässt.

Im Gegensatz zu Probe 6 steigt bei der Probe 8 an der Grenzfläche die Konzentration von Silber scharf an, insgesamt 2,1 at% Ag, und sinkt bei zunehmender Konzentration von Silizium ebenso steil wieder. Der grösste Teil von Silber wird in den 10 nm an der Grenzphase gefunden. Wasserstoff ist wiederum in die obersten Nanometer des Silizium-Wafers hineinmigriert.

Probe 8 zeigt, dass das Schichtmetall auch nur ausgeprägt an der Grenzfläche vorliegen kann. Die Abscheidung erfolgte durch DC-Sputtem mit dem Substrat auf Bias.

Damit die metallhaltige Schicht überhaupt elektrochemisch aktiv sein kann, müssen die metallhaltigen Partikel mindestens lokal in Kontakt mit dem Substrat, hier Silizium, sein. Dies wir in den beiden Tiefenprofiten aufgezeigt.

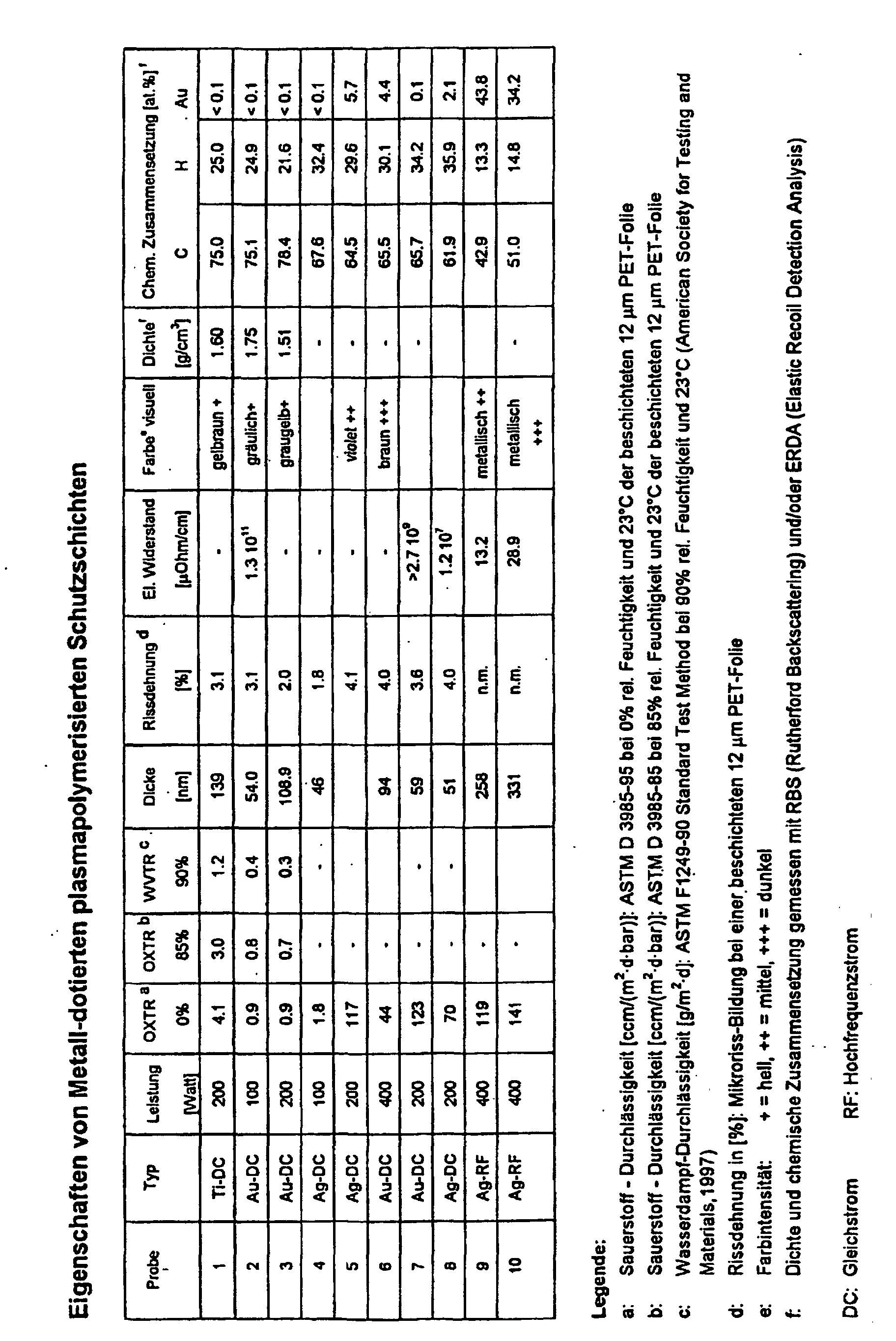

## Patentansprüche

1. Chemische, mechanische und/oder optische Schutz- und/oder Diffusionssperrschicht (16) auf einem Metall- oder Kunststoffsubstrat (14), welche Schicht aus einer organischen Schichtmatrix (10) mit dispergierten metallhaltigen Partikeln (12) besteht, wobei diese Schicht (16) ausgehend von wenigstens einem, auch substituierten Kohlenwasserstoff und einer metallhaltigen Komponente plasmapolymerisiert ist,
**dadurch gekennzeichnet, dass**
die Schutz- und/oder Diffusionssperrschicht (16) in submikroner Dicke (d) mit dispers inkorporierten metallhaltigen Partikeln (12) einer unterhalb 50% der Schichtdicke (d) liegenden Komgrösse vorliegt, wobei die Halbmetalle Tellur und Wismuth enthaltende Partikel ausgeschlossen sind.

2. Schutz- und/oder Diffusionssperrschicht (16) nach Anspruch 1, **dadurch gekennzeichnet, dass** die Komgrösse der metallhaltigen Partikel (12) unterhalb 20%, vorzugsweise unterhalb 10% der Schichtdicke (d) liegt.

3. Schutz- und/oder Diffusionssperrschicht (16) nach Anspruch 1 oder 2, **dadurch gekennzeichnet, dass** für einen kathodischen Korrosionsschutz metallhaltige Partikel (12) inkorporiert sind, welche unedler als das im Substrat (14) vorliegende Metall sind.

4. Schutz- und/oder Diffusionssperrschicht (16) nach Anspruch 1 oder 2, **dadurch gekennzeichnet, dass** für einen anodischen Korrosionsschutz metallhaltige Partikel (12) inkorporiert sind, welche edler als das im Substrat (14) vorliegende Metall sind.

5. Schutz- und/oder Diffusionssperrschicht (16) nach einem der Ansprüche 1 bis 4, **dadurch gekennzeichnet, dass** bei einem zu beschichtenden Metallsubstrat (14) vorerst eine rein metallische Zwischenschicht (18), auf dieser die Schutz- und/oder Diffusionssperrschicht (16) abgeschieden ist, und/oder auf dieser metallhaltige Partikel (12) enthaltenden Schicht (16) wenigstens eine weitere organische Diffusionssperrschicht (26,28) ohne Metallanteil aufgebracht ist.

6. Schutz- und/oder Diffusionssperrschicht (16) nach einem der Ansprüche 1 bis 5, **dadurch gekennzeichnet, dass** die Konzentration der metallhaltigen Partikel mit zunehmender Dicke kontinuierlich niedriger oder höher ist, vorzugsweise mit kontinuierlicher Abnahme der metallhaltigen Partikel (12) in Richtung der Oberfläche (11) bis auf Null.

7. Schutz- und/oder Diffusionssperrschicht (16) nach einem der Ansprüche 1 bis 6, **dadurch gekennzeichnet, dass** über die Dicke (d) von deren organischen Schichtmatrix (10) ein Polaritätsgradient besteht, vorzugsweise ein kontinuierlicher.

8. Schutz- und/oder Diffusionssperrschicht (16) nach einem der Ansprüche 1 bis 7, **dadurch gekennzeichnet, dass** Partikel (12) aus verschiedenen Metallen und/oder metallhaltigen Komponenten inkorporiert sind.

9. Verfahren zum Auftragen einer chemischen, mechanischen und/oder optischen Schutz- und/oder Diffusionsschicht (16) aus einer organischen Schichtmatrix (10) mit dispergierten metallhaltigen Partikeln (12) auf ein Metall- oder Kunststoffsubstrat (14) nach einem der Ansprüche 1 bis 8, wobei die organische Schichtmatrix (10) durch Plasmapolymerisation aus einem Prozessgas mit wenigstens einem, auch substituierten Kohlenwasserstoff, einer metallhaltigen Komponente und/oder einem anorganischen Gas in einem evakuierbaren Reaktor abgeschieden wird,
**dadurch gekennzeichnet, dass**
während des Reaktionsablaufs organische Monomere und unterschiedliche metallhaltige Komponenten in gleichbleibender oder unterschiedlicher Konzentration in den Reaktor eingeleitet werden.

10. Verfahren nach Anspruch 9, **dadurch gekennzeichnet, dass** vorerst polare, dann zunehmend und gegen das Reaktionsende ausschliesslich apolare Monomere oder vorerst apolare, dann zunehmend und gegen das Reaktionsende ausschliesslich polare Monomere eingeleitet werden, vorzugsweise jeweils kontinuierlich ändernd.

11. Verfahren nach Anspruch 9 oder 10, **dadurch gekennzeichnet, dass** die Metallpartikel (12) durch Kathodenzerstäubung eines Targets aus dem betreffenden Metall bei gezündetem Plasma erzeugt und verteilt in die organische Schichtmatrix (10) inkorporiert werden.

12. Verfahren nach einem der Ansprüche 9 bis 11, **dadurch gekennzeichnet , dass** die Metallpartikel (12) durch Verdampfen von entsprechenden Metallstücken, insbesondere mittels Bogenentladung, sowie resistiver oder RF-Erwärmung, erzeugt, vom Prozessgasstrom mitgerissen und verteilt in die organische Schichtmatrix (10) inkorporiert werden.

13. Verfahren nach einem der Ansprüche 9 bis 12, **dadurch gekennzeichnet, dass** wenigstens eine metallorganische Verbindung zersetzt und unter Bildung der organischen Schichtmatrix (10) mit den dispersen Metallpartikeln (12) niedergeschlagen wird.

14. Verfahren nach einem der Ansprüche 9 bis 13, **dadurch gekennzeichnet, dass** gleichzeitig Partikel (12) aus mehreren Metallen in die Schutz- und/oder Diffusionssperrschicht (16) inkorporiert werden, insbesondere durch den Einsatz eines Targets mit verschiedenen Metallsegmenten und/oder von mehreren Kathodenzerstäubern und/oder dem Einleiten einer metallorganischen Verbindung mit verschiedenen metallischen Komponenten.

15. Verfahren nach einem der Ansprüche 9 bis 14, **dadurch gekennzeichnet, dass** das Substrat (14) beim Schichtaufbau mit einem eingeschalteten Bias arbeitet, allenfalls auch erwärmt oder gekühlt wird, wobei DC oder AC mit 10 kHz bis 100 MHz vorgegeben werden.

16. Verwendung der Schutz- und/oder Diffusionsschicht (16) nach einem der Ansprüche 1 bis 8, für eine Korrosionsschutzschicht von metallischen Substraten (14).

17. Verwendung einer Schutz- und/oder Diffusionsschicht (16) nach einem der Ansprüche 1 bis 8, als flexible Diffusionsbarriere mit einstellbarer elektrischer Leitfähigkeit für Kunststoffsubstrate, insbesondere für Kunststoffverpackungen.

18. Anwendung des Verfahrens nach einem der Ansprüche 9 bis 15 zur elektrisch leitenden Beschichtung von Fasern, insbesondere Textil-, Glas-, Keramik- und Metallfasern, Whiskers und Drähten.

## Claims

1. Chemical, mechanical and/or optical protection and/or diffusion barrier layer (16) on a metal or plastic substrate (14), which layer consists of an organic layer matrix (10) with dispersed metal-containing particles (12), where this layer (16) is plasma-polymerised on the basis of at least one possibly substituted hydrocarbon and a metal-containing component,
**characterised in that**
the protection and/or diffusion barrier layer (16) lies in the submicron thickness (d) with dispersed incorporated metal-containing particles (12) of a grain size lying below 50% of the layer thickness (d), where particles containing the metalloids tellurium and bismuth are excluded.

2. Protection and/or diffusion barrier layer (16) according to claim 1, **characterised in that** the grain size of the metal-containing particles (12) lies below 20%, preferably below 10% of the layer thickness (d).

3. Protection and/or diffusion barrier layer (16) according to claim 1 or 2, **characterised in that** for cathodic corrosion protection, metal-containing particles (12) are incorporated which are less refined than the metal present in the substrate (14).

4. Protection and/or diffusion barrier layer (16) according to claim 1 or 2, **characterised in that** for anodic corrosion protection, metal-containing particles (12) are incorporated which are nobler than the metal present in the substrate (14).

5. Protection and/or diffusion barrier layer (16) according to any of claims 1 to 4, **characterised in that** for a metal substrate (14) to be coated first a purely metallic intermediate layer (18) is applied, on this is deposited the protection and/or diffusion barrier layer (16), and/or on this layer (16) with metal-containing particles (12) is applied at least one further organic diffusion barrier layer (26, 28) without metal part.

6. Protection and/or diffusion barrier layer (16) according to any of claims 1 to 5, **characterised in that** the concentration of metal-containing particles continuously decreases or increases as the thickness increases, preferably with a continuous reduction in metal-containing particles (12) in the direction of the surface (11) down to zero.

7. Protection and/or diffusion barrier layer (16) according to any of claims 1 to 6, **characterised in that** there is a polarity gradient, preferably continuous, over the thickness (d) of the organic barrier layer matrix (10).

8. Protection and/or diffusion barrier layer (16) according to any of claims 1 to 7, **characterised in that** particles (12) of different metals and/or metal-containing components are incorporated.

9. Process for application of a chemical, mechanical and/or optical protection and/or diffusion layer (16) from an organic layer matrix (10) with dispersed metal-containing particles (12) on a metal or plastic substrate (14) according to any of claims 1 to 8, where the organic layer matrix (10) is deposited by plasma polymerisation from a process gas with at least one possibly substituted hydrocarbon, a metal-containing component and/or an inorganic gas in an evacuable reactor,
**characterised in that** during the reaction process organic monomers and different metal-containing components of the same or different concentration are introduced into the reactor.

10. Process according to claim 9, **characterised in that** first polar then increasingly and towards the reaction end exclusively non-polar monomers, or first non-polar then increasingly and towards the reaction end exclusively polar monomers, are introduced, preferably in each case changing continuously.

11. Process according to claim 9 or 10, **characterised in that** the metal particles (12) are generated by cathode sputtering of a target from the metal concerned with ignited plasma and incorporated distributed in the organic layer matrix (10).

12. Process according to any of claims 9 to 11, **characterised in that** the metal particles (12) are produced by vaporisation of corresponding metal pieces, in particular by means of arc discharge, and resistive or RF heating, torn from the process gas flow and incorporated distributed in the organic layer matrix (10).

13. Process according to any of claims 9 to 12, **characterised in that** at least one metal organic compound is decomposed and deposited forming the organic layer matrix (10) with the dispersed metal particles (12).

14. Process according to any of claims 9 to 13, **characterised in that** at the same time particles (12) of several metals are incorporated in the protection and/or diffusion barrier layer (16), in particular by the use of a target with various metal segments and/or several cathode sputtering devices and/or the introduction of a metal organic compound with various metal components.

15. Process according to any of claims 9 to 14, **characterised in that** the substrate (14) during layer construction works with a connected bias, in any case is also heated or cooled, where DC or AC at 10 kHz to 100 MHz is specified .

16. Use of the protection and/or diffusion layer (16) according to any of claims 1 to 8 for corrosion protection of metallic substrates (14).

17. Use of a protection and/or diffusion layer (16) according to any of claims 1 to 8 as flexible diffusion barriers with adjustable electrical conductivity for plastic substrates, in particular for plastic packaging.

18. Use of the process according to any of claims 9 to 15 for electrically conductive coating of fibres, in particular textile, glass, ceramic and metal fibres, whiskers and wires.

## Revendications

1. Couche chimique, mécanique et/ou optique (16) de protection et/ou de barrage de diffusion sur un substrat (14) de métal ou de matière plastique, couche qui se compose d'une matrice organique (10) de couche contenant des particules dispersées (12) à teneur métallique, cette couche étant polymérisée par plasma à partir d'au moins un hydrocarbure, éventuellement substitué, et d'un composant à teneur métallique,
**caractérisée en ce que**
la couche (16) de protection et/ou de barrage de diffusion est d'une épaisseur (d) inférieure au micron et contient des particules incorporées (12) à teneur métallique d'une granulométrie inférieure à 50% de l'épaisseur (d) de couche, des particules contenant les métalloïdes tellure et bismuth étant exclues.

2. Couche (16) de protection et/ou de barrage de diffusion selon la revendication 1, **caractérisée en ce que** la granulométrie des particules (12) à teneur métallique est inférieure à 20%, de préférence inférieure à 10% de l'épaisseur (d) de couche.

3. Couche (16) de protection et/ou de barrage de diffusion selon la revendication 1 ou 2, **caractérisée en ce que** des particules (12) qui contiennent des métaux qui sont moins nobles que le métal présent dans le substrat (14) sont incorporées pour atteindre une protection anti-corrosion cathodique.

4. Couche (16) de protection et/ou de barrage de diffusion selon la revendication 1 ou 2, **caractérisée en ce que** des particules (12) qui contiennent des métaux qui sont plus nobles que le métal présent dans le substrat (14) sont incorporées pour atteindre une protection anti-corrosion anodique.

5. Couche (16) de protection et/ou de barrage de diffusion selon l'une quelconque des revendications précédentes, **caractérisée en ce que**, dans le cas d'un substrat métallique (14) à revêtir, une couche intermédiaire purement métallique (18) est d'abord déposée et la couche (16) de protection et/ou de barrage de diffusion est déposée sur celle-ci, et/ou au moins une autre couche organique (26, 28) de barrage de diffusion sans teneur métallique est appliquée sur cette couche (16) contenant des particules (12) à teneur métallique.

6. Couche (16) de protection et/ou de barrage de diffusion selon l'une quelconque des revendications précédentes, **caractérisée en ce que** la concentration des particules à teneur métallique diminue ou augmente en continu lorsque l'épaisseur augmente, la teneur en particules (12) à teneur métallique décroissant de préférence en continu en direction de la surface (11) pour atteindre zéro.

7. Couche (16) de protection et/ou de barrage de diffusion selon l'une quelconque des revendications précédentes, **caractérisée par** l'existence d'un gradient de polarité, de préférence continu, sur l'épaisseur (d) à partir de sa matrice organique (10) de couche.

8. Couche (16) de protection et/ou de barrage de diffusion selon l'une quelconque des revendications précédentes, **caractérisée en ce que** des particules (12) de divers métaux et/ou composants à teneur métallique sont incorporées.

9. Procédé d'application d'une couche chimique, mécanique et/ou optique (16) de protection et/ou de diffusion consistant en en une matrice organique (10) de couche contenant des particules dispersées (12) à teneur métallique sur un substrat (14) en métal ou en matière plastique selon l'une quelconque des revendications précédentes, dans lequel la matrice organique (10) de couche est déposée, dans un réacteur susceptible d'être mis en dépression, par polymérisation plasma à partir d'un gaz de traitement contenant au moins un hydrocarbure, éventuellement substitué, un composant à teneur métallique et/ou un gaz inorganique,
**caractérisé en ce que**
des monomères organiques et divers composants à teneur métallique sont introduits à concentration constante ou variable dans le réacteur au cours de la réaction.

10. Procédé selon la revendication 9, **caractérisé par** l'introduction, de préférence d'une manière variant respectivement en continu, soit de monomères d'abord polaires, puis de plus en plus apolaires et exclusivement apolaires vers la fin de la réaction, soit de monomères d'abord apolaires, puis de plus en plus polaires et exclusivement polaires vers la fin de la réaction.

11. Procédé selon la revendication 9 ou 10, **caractérisé en ce que** les particules métalliques (12) sont engendrées, après allumage du plasma, par pulvérisation cathodique d'une cible du métal correspondant et sont ensuite incorporées de façon répartie dans la matrice organique (10) de couche.

12. Procédé selon l'une quelconque des revendications 9 à 11 **caractérisé en ce que** les particules métalliques (12) sont engendrées par évaporation d'éléments métalliques correspondants, en particulier par décharge d'arc ainsi que par échauffement par résistance ou RF, sont entraînées par le flux de gaz de traitement et sont incorporées de façon répartie dans la matrice organique (10) de couche.

13. Procédé selon l'une quelconque des revendications 9 à 12, **caractérisé en ce qu'**au moins un composé organométallique est décomposé et est précipité avec les particules métalliques dispersées (12) en formant la matrice organique (10) de couche.

14. Procédé selon l'une quelconque des revendications 9 à 13, **caractérisé en ce que** des particules (12) de plusieurs métaux sont incorporées simultanément dans la couche de protection et/ou de barrage de diffusion, en particulier en utilisant une cible à divers segments métalliques différents et/ou plusieurs pulvérisateurs cathodiques et/ou en introduisant un composé organométallique à divers composants métalliques.

15. Procédé selon l'une quelconque des revendications 9 à 14, **caractérisé en ce que**, lors de l'élaboration de la couche, une polarisation est appliquée au substrat, celui-ci est de plus éventuellement chauffé ou refroidi, et une tension en courant continu ou en courant alternatif de 10 kHz à 100 MHz lui est appliquée.

16. Utilisation de la couche (16) de protection et/ou de barrage de diffusion selon l'une quelconque des revendications 1 à 8, pour former une couche de protection anti-corrosion de substrats métalliques (14).

17. Utilisation d'une couche (16) de protection et/ou de barrage de diffusion selon l'une quelconque des revendications 1 à 8, sous forme de barrage flexible de diffusion à conductibilité électrique réglable pour des substrats en matière plastique, en particulier pour des emballages en matière plastique.

18. Utilisation du procédé selon l'une quelconque des revendications 9 à 15 pour appliquer un revêtement électriquement conducteur sur des fibres, en particulier des fibres de matières textiles, de verre, de céramique et de métaux, des barbes et des fils.
